# EUROPÄISCHE PATENTSCHRIFT

(11) **EP 2 370 612 B1**
(45) Veröffentlichungstag und Bekanntmachung des Hinweises auf die Patenterteilung: **20.05.2015**
(21) Anmeldenummer: 09799342.2
(22) Anmeldetag: 18.12.2009
(51) Int. Cl.: C23C 14/50, C23C 14/56, C23C 16/458, C23C 16/54, B01J 3/00, B01J 3/02, F16H 1/00

(54) **IN-LINE-VAKUUMBESCHICHTUNGSANLAGE**
IN-LINE VACUUM COATING SYSTEM
INSTALLATION DE REVÊTEMENT SOUS VIDE EN LIGNE

(30) Priorität: 22.12.2008 DE 102008064183
(43) Veröffentlichungstag der Anmeldung: 05.10.2011
(73) Patentinhaber: FHR Anlagenbau GmbH, 01458 Ottendorf-Okrilla (DE)
(72) Erfinder: PFITZNER, Manfred, 01139 Dresden (DE); SICKERT, Günther, 01328 Dresden (DE); KAISER, Roberto, 01219 Dresden (DE); VOGT, Andreas, 01259 Dresden (DE)
(74) Vertreter: Lippert, Stachow & Partner
(86) Internationale Anmeldenummer: PCT/EP2009/067557
(87) Internationale Veröffentlichungsnummer: WO 2010/072686

(56) Entgegenhaltungen:
- US-A1- 2008 276 451

## Beschreibung

Die Erfindung betrifft eine In-Line-Vakuumbeschichtungsanlage mit einer Vakuumkammer, mindestens einer Beschichtungseinheit sowie einem durch die Vakuumkammer verfahrbaren Carrier zur Aufnahme von rohrförmigen Substraten.

Beim Einsatz eines Carriers in In-Line-Durchlaufanlagen werden die Substrate üblicher weise statisch fixiert, um dann während einer Vorbeifahrt an einer Beschichtungsquelle beschichtet zu werden. Unter einem Carrier soll nachfolgend ein Substratträger verstanden werden, in dem die rohrförmigen Substrate abstandsweise übereinander und um ihre Längsachse drehbar positionierbar sind.

Bei flächigen Substraten ist das ohne weiteres möglich, wohingegen dieses bei rotationssymmetrischen Substraten, wie Rohren, die zudem ungleich länger als handelsübliche Beschichtungsquellen sind, die Substratachse um 90° gegenüber der Beschichtungsquelle in die horizontale Ebene gedreht ist.

Um auch hier eine gleichmäßige Beschichtung bei der Vorbeifahrt an einer Beschichtungsquelle zu gewährleisten, sind derartige Substrate auf einem Carrier angeordnet. In der Regel sind mehrere Substrate auf einem Carrier gleichzeitig angeordnet.

Im Interesse einer hohen Schichthomogenität auf der Mantelfläche des Substrates müssen die Substrate sowohl relativ zur Quelle in Richtung der Längsachse bewegt, als auch um ihre Längsachse gedreht werden. Hierfür sind zwei Antriebe erforderlich, die unabhängig voneinander regelbar sein müssen, damit die Vorschubgeschwindigkeit des Carriers und die Rotationsgeschwindigkeit der Substrate entsprechend eingestellt werden können. Auf diese Weise lässt sich die notwendige Schichthomogenität der schraubenförmig aufgebrachten Beschichtung erreichen, wobei sich die Beschichtung zudem unterbrechungsfrei über die gesamte Oberfläche der Substrate erstrecken sollte.

Aus der US 2008/276451A1 geht eine Beschichtungskammer zur Inline-Abscheidung von Materialien auf eine nicht ebene Oberfläche hervor. Es handelt sich um rohrförmige Substrate, die quer oder längs zur Transportrichtung in einem Carrier drehbar gelagert sind. Die erforderliche Drehung der Substrate erfolgt mittels Zahnrädern, die mit Zahnstangen in Eingriff stehen, wobei die Übertragung der Drehbewegung auf die Substrate mittels Riementrieb erfolgt. Die Drehung der Substrate erfolgt während des Transports des Carriers durch die Beschichtungskammer.

Der Erfindung liegt die Aufgabe zugrunde, eine In-Line-Vakuumbeschichtungsanlage mit einer Vakuumbeschichtungskammer, mindestens einer Beschichtungseinheit sowie einem durch die Vakuumkammer verfahrbaren Carrier zu schaffen, bei der eine einfache und sichere und verschleißarme Kopplung eines fest stehenden Drehantriebes mit dem mit konstanter Geschwindigkeit verfahrbaren Carrier gewährleistet wird.

Erreicht wird das durch eine ortsfest installierte drehbare und mit einem Drehantrieb verbundene Zahnwelle und ein mit der Zahnwelle in Eingriff bringbares und am Carrier drehbar gelagertes Zahnrad, welches federbelastet entgegen der Fahrrichtung des Carriers um einen vorgegebenen Betrag längs verschiebbar ist.

Das Zahnrad ist geradverzahnt.

Die Federbelastung des Zahnrades wird dadurch erreicht, dass das Zahnrad zwischen zwei Druckfedern federbelastet in einer Ausgangsposition positioniert wird.

Alternativ ist bei nur einer Fahrtrichtung das Zahnrad federbelastet in einer Ausgangsposition an einem Anschlag positioniert, der sich in Fahrtrichtung gesehen, hinter der Ausgangsposition befindet.

In beiden Fällen erfolgt bereits nach einer geringfügigen Auslenkung des Zahnrades aus der Ausgangsposition ein Einspuren in die Verzahnung der Zahnwelle.

In Fortführung der Erfindung ist das Zahnrad auf einer am Carrier befestigten Welle geführt.

Weiterhin ist das Zahnrad auf der im Carrier drehbaren Welle formschlüssig längs verschiebbar, wodurch eine Drehbewegung des Zahnrades auf die Welle übertragen werden kann.

Schließlich ist an der Welle einends eine Riemenscheibe zur Aufnahme eines Transmissionsbandes befestigt, das antriebsseitig auf der Riemenscheibe und abtriebsseitig auf einer weiteren Riemenscheibe abläuft, die mit weiteren Rollen gekoppelt ist.

Die Kopplung der weiteren Riemenscheibe mit den weiteren Rollen erfolgt durch Friktionskupplung, oder auch mittels Zahnräder.

In einer weiteren Ausgestaltung der Erfindung sind die weitere Riemenscheibe und die weiteren Rollen in einem Rahmen des Carriers drehbar gelagert.

Um rohrförmige Substrate drehbar fassen zu können, sind die weiteren Rollen jeweils in axialer Richtung mit einer Kegelaufnahme zur Fixierung der Stirnseite des rohrförmigen Substrates versehen, wobei die jeweils andere Stirnseite des rohrförmigen Substrates auf entsprechende Weise gelagert ist. Es versteht sich, dass die beiden somit gegenüber liegenden Kegelaufnahmen zur sicheren Halterung der rohrförmigen Substrate gegeneinander gedrückt werden, beispielsweise federbelastet, nachdem die Substrate zwischen den Kegelaufnahmen positioniert worden sind.

Weiterhin ist die Zahnwelle als Hauptantrieb ortsfest in der Vakuumkammer gelagert, und zwar derart in Bezug auf das am Carrier befindliche Zahnrad, dass dieses in Eingriffposition mit der Zahnwelle über deren Längserstreckung kämmt.

Der Begriff rohrförmiges Substrat steht nicht nur beispielsweise für Rohre, sondern soll auch für sämtliche längs erstreckte Substrate, wie Profilrohre und Profilstangen, o.dgl., gelten, die in der In-Line-Vakuumanlage rundum beschichtet werden sollen.

Im Folgenden wird die Erfindung an einem Ausführungsbeispiel näher erläutert. In den zugehörigen Zeichnungen zeigen:
- Fig. 1:: eine schematische Übersichtsdarstellung einer In-Line-Vakuumbeschichtungsanlage mit einem Carrier, der mit rohrförmigen Substraten bestückt ist;
- Fig. 2:: einen vergrößerten Ausschnitt des Carriers mit Einzelheiten des Antriebes; und
- Fig. 3:: eine Schnittdarstellung der Stirnansicht der In-Line-Vakuumbeschichtungsanlage mit darin befindlichem Carrier in Eingriffsposition mit einer sich längs durch die Vakuumkammer erstreckenden Zahnwelle.

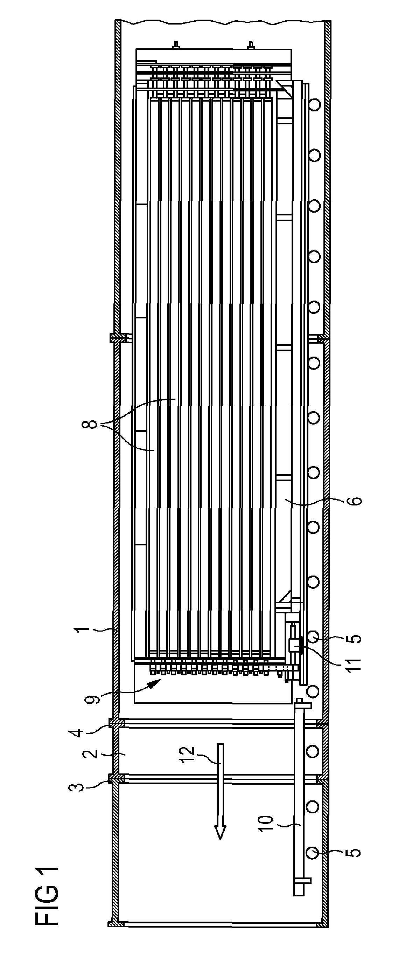

Gemäß der Übersichtsdarstellung in Fig. 1 enthält die In-Line-Vakuumbeschichtungsanlage 1 eine Vakuumkammer 2 mit eingangs- und ausgangsseitigen Vakuum-Schleusen 3, 4 und eine Führungs- und Transporteinrichtung, schematisch dargestellt durch Rollen 5, zum Transport eines Carriers 6 längs durch die In-Line-Vakuumbeschichtungskammer 1.

Der Carrier 6 enthält einen Tragrahmen 7, in dem mehrere rohrförmige Substrate 8 übereinander mittels einer Antriebseinheit 9 um ihre Längsachse drehbar gehaltert sind.

Weiterhin befindet sich in der In-Line-Vakuumbeschichtungskammer 1 in deren unterem Bereich eine sich längs des Transportweges des Carriers 6 erstreckende und ortsfest gelagerte Zahnwelle 10. Diese Zahnwelle 10 ist mit einem nicht dargestellten Drehantrieb gekoppelt, wobei sich die Zahnwelle 10 durch die Vakuumkammer 2 erstreckt. Die Länge der Zahnwelle 10 entspricht der Länge das Carriers 6, wie noch zu erläutern ist.

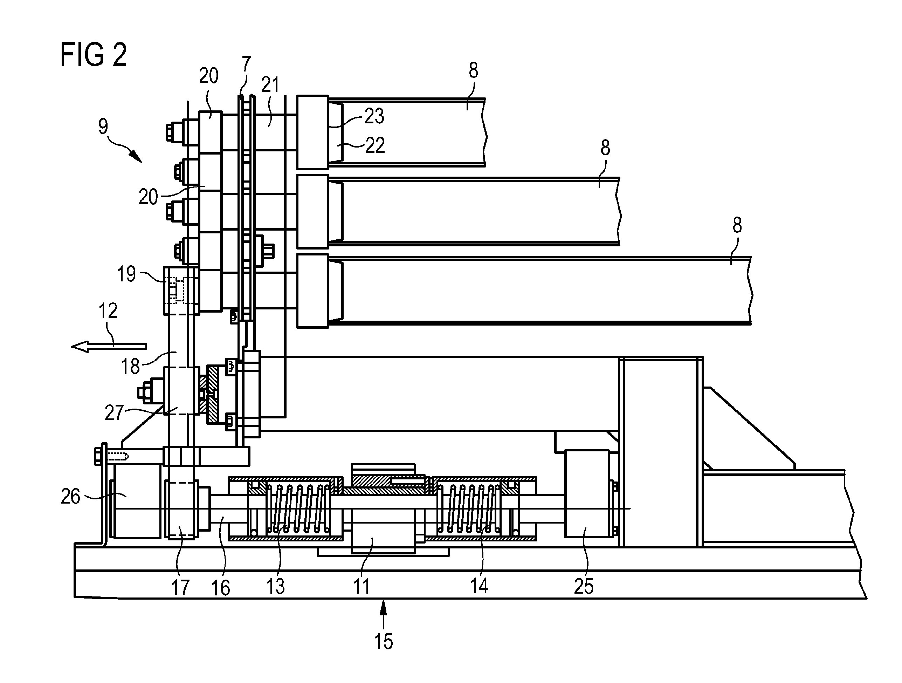

Aus Fig. 2 sind nun Einzelheiten der Antriebseinheit 9 des Carriers 6 ersichtlich. Am Carrier 6 befindet sich ein drehbar gelagertes Zahnrad 11, welches zwischen zwei Druckfedern 13, 14 federbelastet in einer Ausgangsposition 15 auf einer am Carrier 6 drehbar in Lagerböcken 25, 26 gelagerten Welle 16 gehalten wird. Diese Ausgestaltung der Erfindung ist vor allem dann notwendig, wenn der Carrier 6 auch entgegen der Fahrtrichtung 12 durch die In-line-Vakuumbeschichtungsanlage 1 gefahren werden soll, um beispielsweise eine größere Schichtdicke zu erreichen.

Soll nur in einer Fahrtrichtung 12 durch die In-line-Vakuumbeschichtungsanlage 1 gefahren werden, reicht es aus, wenn das Zahnrad 11 federbelastet in einer Ausgangsposition 15 an einem Anschlag positioniert wird, wobei sich der Anschlag in Fahrtrichtung 12 gesehen, hinter der Ausgangsposition 15 befindet, so dass das Zahnrad 11 beim Berühren der Zahnwelle 10 ausweichen kann.

Das Zahnrad 11 ist auf der drehbaren Welle 16 formschlüssig längs verschiebbar, wodurch eine dem Zahnrad 11 vermittelte Drehbewegung auf die Welle 16 übertragen wird.

An der Welle 16 befindet sich einends, hier zeichnungsgemäß am linken Ende, eine Riemenscheibe 17 zur Aufnahme eines Transmissionsbandes 18. Dieses Transmissionsband 18 läuft antriebsseitig auf der Riemenscheibe 17 und abtriebsseitig auf einer weiteren Riemenscheibe 19 ab, die mit weiteren Rollen 20 gekoppelt ist. Zwischen beiden Riemenscheiben 17, 19 befindet sich noch eine Spannrolle 27. Die Kopplung der weiteren Riemenscheibe 19 mit den weiteren Rollen 20 erfolgt durch eine Friktionskupplung oder auch durch Zahnräder, bzw. eine entsprechende Verzahnung.

Die weitere Riemenscheibe 19 und die weiteren Rollen 20 sind im Tragrahmen 7 des Carriers 6 drehbar gelagert.

Um rohrförmige Substrate 8 drehbar fassen zu können, sind die weiteren Rollen 20 jeweils in axialer Richtung über einen Achsstumpf 21 einer Kegelaufnahme 22 zur Fixierung der Stirnseite 23 des rohrförmigen Substrates 8 versehen, wobei die jeweils andere Stirnseite 23 des rohrförmigen Substrates 8 auf entsprechende Weise gelagert ist. Es versteht sich, dass die beiden somit gegenüber liegenden Kegelaufnahmen 22 zur sicheren Halterung der rohrförmigen Substrate 8 gegeneinander verspannt werden, beispielsweise federbelastet.

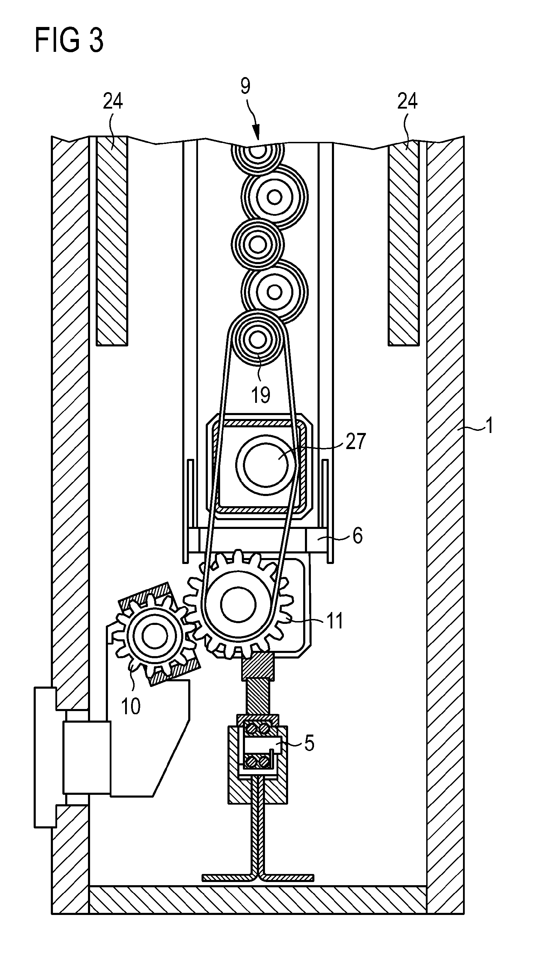

Weiterhin ist die Zahnwelle 10 als Hauptdrehantrieb ortsfest in der Vakuumkammer 2 gelagert, und zwar derart in Bezug auf das am Carrier 6 befindliche Zahnrad 11, dass dieses in Eingriffposition, wie in Fig. 3 dargestellt, mit der Zahnwelle 10 über deren Längserstreckung kämmt.

Wird nun der Carrier 6 in Fahrtrichtung 12 in Richtung zur Vakuumkammer 2 mittels der drehbar angetriebenen Rollen 5 gefahren, so kommt das Zahnrad 11 am Carrier 6 mit der Stirnseite der Zahnwelle 10 in Kontakt. Da die Stellung der Verzahnung des Zahnrades 11 in Bezug auf die Verzahnung der Zahnwelle 10 im Kontaktzeitpunkt beliebig ist, wird die Verzahnung der Welle 10 und des Zahnrades 11 in den seltensten Fällen sofort kämmen. Da das Zahnrad 11 aber federbelastet aus der Ausgangsposition 15 verschiebbar ist, erfolgt infolge der eintretenden Friktion eine Relativbewegung bis die Verzahnungen kämmen, wie aus Fig. 3 ersichtlich ist. Es hat sich überraschender Weise gezeigt, dass dies sehr schnell und bereits nach einer nur kurzen Relativbewegung der Fall ist.

Während der Weiterbewegung des Carriers 6 durch die Vakuumkammer ist damit sicher gestellt, dass ein kontinuierlicher Kontakt zwischen der Zahnwelle 10 und dem Zahnrad 11 gesichert ist. Durch die mit einem nicht dargestellten Drehantrieb gekoppelte Zahnwelle 10 ist ein kontinuierlicher Drehantrieb der Riemenscheibe 15 gesichert. Damit erfolgt auch während des Transportes des Carriers 6 entlang der Zahnwelle 10 durch die Vakuumbeschichtungskammer 2 eine kontinuierliche Drehbewegung der rohrförmigen Substrate 8, wodurch in Verbindung mit dem Transportantrieb des Carriers 6 mittels der Rollen 5 eine gleichmäßige schraubenförmige, aber lückenlose Beschichtung der rohrförmigen Substrate mittels der schematisch in Fig. 3 dargestellten Beschichtungseinheiten 24 während deren Durchfahrt durch die Vakuumbeschichtungskammer 2 erfolgt. Als Beschichtungseinheit 24 kommen beispielsweise Plasmatrone in Betracht, die auf einer oder auf beiden Seiten des Carriers 6 in der Vakuumbeschichtungskammer 2 sind.

Anstelle der in Fig. 3 schematisch angedeuteten Beschichtungseinheiten 24, die rechts und links des Transportweges des Carriers 6 in der Vakuumbeschichtungskammer 2 angeordnet sind, ist selbstverständlich auch eine Anordnung mit nur einer Beschichtungseinheit 24 möglich.

Es versteht sich, dass die Zahnwelle 10 mindestens so lang sein muss, wie der Carrier 6 bzw. die rohrförmigen Substrate 8.

Alternativ kann bei gleicher Funktion auch die Zahnwelle 10, ähnlich wie das Zahnrad 11, federbelastet längs verschiebbar gelagert sein, wohingegen das Zahnrad 11 in diesem Fall fest auf der Welle 16 befestigt sein muss.

### Bezugszeichenliste

- 1: In-Line-Vakuumbeschichtungsanlage
- 2: Vakuumbeschichtungskammer
- 3: Vakuumschleuse
- 4: Vakuumschleuse
- 5: Rolle
- 6: Carrier
- 7: Tragrahmen
- 8: rohrförmiges Substrat
- 9: Antriebseinheit
- 10: Zahnwelle
- 11: Zahnrad
- 12: Fahrtrichtung
- 13: Druckfeder
- 14: Druckfeder
- 15: Ausgangsposition
- 16: Welle
- 17: Riemenscheibe
- 18: Transmissionsband
- 19: weitere Riemenscheibe
- 20: weitere Rollen
- 21: Achsstumpf
- 22: Kegelaufnahme
- 23: Stirnseite
- 24: Beschichtungseinheit
- 25: Lagerbock
- 26: Lagerbock
- 27: Spannrolle

## Patentansprüche

1. In-Line-Vakuumbeschichtungsanlage mit einer Vakuumbeschichtungskammer mit mindestens einer Beschichtungseinheit sowie einem durch die Vakuumbeschichtungskammer verfahrbaren Carrier zur Aufnahme von um deren Längsachse drehbaren rohrförmigen Substraten, **gekennzeichnet durch** eine ortsfest installierte drehbare und mit einem Drehantrieb verbundene Zahnwelle (10) und ein mit der Zahnwelle (10) in Eingriff bringbares und am Carrier (6) drehbar gelagertes Zahnrad (11), welches federbelastet entgegen der Fahrrichtung (12) des Carriers (6) um einen vorgegebenen Betrag längs verschiebbar ist.

2. In-Line-Vakuumbeschichtungsanlage nach Anspruch 1, **dadurch gekennzeichnet, dass** das Zahnrad (11) geradverzahnt ist.

3. In-Line-Vakuumbeschichtungsanlage nach Anspruch 1 und 2, **dadurch gekennzeichnet, dass** das Zahnrad (11) zwischen zwei Druckfedern (13, 14) federbelastet in einer Ausgangsposition (15) positioniert ist.

4. In-line-Vakuumbeschichtungsanlage nach Anspruch 1 und 2, **dadurch gekennzeichnet, dass** das Zahnrad (11) federbelastet in einer Ausgangsposition (15) an einem Anschlag positioniert ist, der sich in Fahrtrichtung (12) gesehen, hinter der Ausgangsposition (15) befindet.

5. In-Line-Vakuumbeschichtungsanlage nach Anspruch 3 oder 4, **dadurch gekennzeichnet, dass** das Zahnrad (11) auf einer ortsfest am Carrier (6) befestigten Welle (16) geführt ist.

6. In-Line-Vakuumbeschichtungsanlage nach Anspruch 3 oder 4, **dadurch gekennzeichnet,** das das Zahnrad (11) auf einer ortsfest im Carrier (6) drehbaren Welle (16) formschlüssig längs verschiebbar ist.

7. In-Line-Vakuumbeschichtungsanlage nach Anspruch 6, **dadurch gekennzeichnet, dass** die Welle (16) einends mit einer Riemenscheibe (17) zur Aufnahme eines Transmissionsbandes (18) versehen ist, das antriebsseitig auf der Riemenscheibe (17) und abtriebsseitig auf einer weiteren Riemenscheibe (19) ablauft, die mit weiteren Rollen (20) gekoppelt ist.

8. In-Line-Vakuumbeschichtungsanlage nach Anspruch 7, **dadurch gekennzeichnet, dass** die Kopplung der weiteren Riemenscheibe (19) mit den weiteren Rollen (20) durch Friktionskupplung oder Zahnräder erfolgt.

9. In-Line-Vakuumbeschichtungsanlage nach Anspruch 7 und 8, **dadurch gekennzeichnet, dass** die weitere Riemenscheibe (19) und die weiteren Rollen (20) in einem Tragrahmen (7) des Carriers (6) drehbar gelagert sind.

10. In-Line-Vakuumbeschichtungsanlage nach den Ansprüchen 7 bis 9, **dadurch gekennzeichnet, dass** die weiteren Rollen (20) jeweils in axialer Richtung mit einer Kegelaufnahme (22) zur Fixierung der Stirnseite (23) eines rohrförmigen Substrates (8) versehen sind, wobei die jeweils andere Stirnseite des rohrförmigen Substrates (8) auf entsprechende Weise gefasst ist.

11. In-Line-Vakuumbeschichtungsanlage nach Anspruch 1, **dadurch gekennzeichnet, dass** die Zahnwelle (10) ortsfest in der Vakuumbeschichtungskammer (2) gelagert ist, und zwar derart in Bezug auf das am Carrier (6) befindliche Zahnrad (11), dass dieses in Eingriffposition mit der Zahnwelle (10) über deren Längserstreckung kämmt.

## Claims

1. In-line vacuum coating system having a vacuum coating chamber having at least one coating unit and a carrier, that can be moved through the vacuum coating chamber, for holding tubular substrates that can be rotated about their longitudinal axis, **characterized by** a rotatable toothed shaft (10) which is installed in a fixed position and is connected to a rotary drive, and by a gearwheel (11) which can be brought into engagement with the toothed shaft (10), is mounted in a rotatable manner on the carrier (6) and can be moved longitudinally under spring loading by a predefined distance counter to the direction of travel (12) of the carrier (6).

2. In-line vacuum coating system according to Claim 1, **characterized in that** the gearwheel (11) has straight teeth.

3. In-line vacuum coating system according to Claims 1 and 2, **characterized in that** the gearwheel (11) is positioned in a starting position (15) under spring loading between two compression springs (13, 14).

4. In-line vacuum coating system according to Claims 1 and 2, **characterized in that** the gearwheel (11) is positioned under spring loading in a starting position (15) against a stop which, as seen in the direction of travel (12) is located downstream of the starting position (15).

5. In-line vacuum coating system according to Claim 3 or 4, **characterized in that** the gearwheel (11) is guided on a shaft (16) that is secured in a fixed position to the carrier (6).

6. In-line vacuum coating system according to Claim 3 or 4, **characterized in that** the gearwheel (11) can be moved longitudinally in a positively locking manner on a shaft (16) which can be rotated in a fixed position in the carrier (6).

7. In-line vacuum coating system according to Claim 6, **characterized in that** the shaft (16) is provided at one end with a pulley (17) for holding a transmission belt (18), which runs on the drive-input side on the pulley (17) and on the drive-output side on a further pulley (19) which is coupled to further rollers (20).

8. In-line vacuum coating system according to Claim 7, **characterized in that** the further pulley (19) is coupled to the further rollers (20) by way of frictional coupling or gearwheels.

9. In-line vacuum coating system according to Claims 7 and 8, **characterized in that** the further pulley (19) and the further rollers (20) are mounted in a rotatable manner in a support frame (7) of the carrier (6).

10. In-line vacuum coating system according to Claims 7 to 9, **characterized in that** the further rollers (20) are each provided in the axial direction with a conical holder (22) for fixing the end side (23) of a tubular substrate (8), wherein the respectively other end side of the tubular substrate (8) is gripped in a corresponding manner.

11. In-line vacuum coating system according to Claim 1, **characterized in that** the toothed shaft (10) is mounted in a fixed position in the vacuum coating chamber (2), specifically in such a way in relation to the gearwheel (11) located on the carrier (6) that in the engagement position said gearwheel (11) meshes with the toothed shaft (10) over the longitudinal extent thereof.

## Revendications

1. Installation de revêtement sous vide en ligne comprenant une chambre de revêtement sous vide avec au moins une unité de revêtement ainsi qu'un support déplaçable à travers la chambre de revêtement sous vide pour recevoir des substrats de forme tubulaire pouvant tourner autour de leur axe longitudinal, **caractérisée par** un arbre denté rotatif (10) installé fixement et connecté à un entraînement en rotation et par une roue dentée (11) pouvant être amenée en prise avec l'arbre denté (10) et supportée à rotation sur le support (6), laquelle peut être déplacée longitudinalement dans une mesure prédéterminée par sollicitation d'un ressort à l'encontre de la direction de déplacement (12) du support (6).

2. Installation de revêtement sous vide en ligne selon la revendication 1, **caractérisée en ce que** la roue dentée (11) présente une denture droite.

3. Installation de revêtement sous vide en ligne selon les revendications 1 et 2, **caractérisée en ce que** la roue dentée (11), sollicitée par ressort entre deux ressorts de compression (13, 14), est positionnée dans une position de départ (15).

4. Installation de revêtement sous vide en ligne selon les revendications 1 et 2, **caractérisée en ce que** la roue dentée (11), sollicitée par ressort dans une position de départ (15), est positionnée contre une butée qui, vue dans la direction de déplacement (12), se trouve derrière la position de départ (15).

5. Installation de revêtement sous vide en ligne selon la revendication 3 ou 4, **caractérisée en ce que** la roue dentée (11) est guidée sur un arbre (16) fixé fixement au support (6).

6. Installation de revêtement sous vide en ligne selon la revendication 3 ou 4, **caractérisée en ce que** la roue dentée (11) peut être déplacée longitudinalement par engagement par correspondance de formes sur un arbre (16) pouvant tourner fixement dans le support (6).

7. Installation de revêtement sous vide en ligne selon la revendication 6, **caractérisée en ce que** l'arbre (16) est pourvu à une extrémité d'une poulie à courroie (17) pour recevoir une courroie de transmission (18), qui passe du côté de l'entraînement sur la poulie à courroie (17) et du côté de la sortie sur une poulie à courroie supplémentaire (19) qui est accouplée à d'autres poulies (20).

8. Installation de revêtement sous vide en ligne selon la revendication 7, **caractérisée en ce que** l'accouplement de la poulie à courroie supplémentaire (19) aux autres poulies (20) s'effectue par accouplement par friction ou par des roues dentées.

9. Installation de revêtement sous vide en ligne selon les revendications 7 et 8, **caractérisée en ce que** la poulie à courroie supplémentaire (19) et les autres poulies (20) sont supportées à rotation dans un cadre porteur (7) du support (6).

10. Installation de revêtement sous vide en ligne selon les revendications 7 à 9, **caractérisée en ce que** les autres poulies (20) sont pourvues à chaque fois dans la direction axiale d'un logement conique (22) pour fixer le côté frontal (23) d'un substrat de forme tubulaire (8), l'autre côté frontal respectif du substrat de forme tubulaire (8) étant saisi de manière correspondante.

11. Installation de revêtement sous vide en ligne selon la revendication 1, **caractérisée en ce que** l'arbre denté (10) est supporté fixement dans la chambre de revêtement sous vide (2), et ce, par rapport à la roue dentée (11) se trouvant sur le support (6), de telle sorte que celle-ci s'engrène dans la position d'engagement avec l'arbre denté (10) sur son étendue longitudinale.
